**Europäisches Patentamt**

**European Patent Office**

**Office européen des brevets**

(19)

(11) Veröffentlichungsnummer: **0 009 135**
**A1**

# (12) EUROPÄISCHE PATENTANMELDUNG

(21) Anmeldenummer: **79103134.7**

(22) Anmeldetag: **24.08.79**

(51) Int. Cl.³: **H 01 L 21/96, H 01 L 23/04**

(30) Priorität: **20.09.78 DE 2840972**

(43) Veröffentlichungstag der Anmeldung: **02.04.80**
**Patentblatt 80/7**

(84) Benannte Vertragsstaaten: **AT BE CH FR GB IT NL**

(71) Anmelder: **SIEMENS AKTIENGESELLSCHAFT Berlin und München, Postfach 22 02 61, D-8000 München 22 (DE)**

(72) Erfinder: **Andrascek, Ernst, Franz-Wolter-Strasse 13, D-8000 München 81 (DE)**
Erfinder: **Hadersbeck, Hans, Pistorinistrasse 14, D-8000 München 90 (DE)**
Erfinder: **Hacke, Hans-Jürgen, Dipl.-Ing., Wastl-Witt-Strasse 8b, D-8000 München 21 (DE)**
Erfinder: **Freitag, Theodor, Dipl.-Phys., Ostpreussen-Strasse 6, D-8012 Ottobrunn (DE)**

(54) **Verfahren zur Herstellung einer Kunststoffkapselung für Halbleiterbauelemente auf metallischen Systemträgern und nach diesem Verfahren hergestellte Kunststoffkapselung.**

(57) Einfache und kostengünstige Kunststoffkapselung von Halbleiterbauelementen bestehend aus zwei durch Pressen oder Spritzen hergestellten Kunststofformteilen (7, 8), die in einer Preßvorrichtung nach genauer Positionierung über und unter dem Systemträger (5) mit dem Chip (6) zusammengedrückt werden.

EP 0 009 135 A1

BEZEICHNUNG GEÄNDERT
siehe Titelseite

SIEMENS AKTIENGESELLSCHAFT          Unser Zeichen
Berlin und München                 VPA  78 P 7 1 2 7

Verfahren zur Herstellung einer Kunststoffkapselung für
Halbleiterbauelemente auf metallischen Systemträgern.

Bisher werden Halbleiterbauelemente auf metallischen
Systemträgern vollständig mit Kunststoff umspritzt, vergossen oder verklebt. Beim Umspritzen kann es vorkommen,
daß die Kontaktierung beschädigt wird, insbesondere aber
daß die dünnen Verbindungsdrähte abreißen. Im Fall eines
Opto-IC's ist ein Umspritzen wegen des Durchbruchs über
dem Chip werkzeugmäßig äußerst aufwendig, wenn nicht sogar unmöglich.

Der Erfindung liegt die Aufgabe zugrunde, mit möglichst
einfachen Mitteln ein Verfahren zur Herstellung einer
Kunststoffkapselung für Halbleiterbauelemente auf
metallischen Systemträgern zu schaffen. Diese Aufgabe
wird dadurch gelöst, daß vorgefertigte Kunststoffhalbschalen über und unter dem Systemträger mit dem Chip
definiert positioniert, der Systemträger kurzzeitig erwärmt und während dessen beide Halbschalen zusammengedrückt werden. Auf diese Weise ist es möglich, ein

Wed 1 Plr/15.9.1978

schützendes Gehäuse für ein Halbleiterbauelement zu erzielen.

Unter Kontaktdruck und Erwärmung der dazwischenliegenden Metallspinne wird dabei ein lokales Fließen des Kunststoffes erreicht und eine Verbindung aller Teile hergestellt. Der Vorgang ist einfach und kostengünstig, weil nahezu unabhängig von der Form der Metallspinne immer gleiche Formteile verwendet werden können.

Nach einer weiteren Ausgestaltung der Erfindung können die Formteile Höhlungen oder Durchbrüche aufweisen, die vor dem Kapseln mit einer Wärmeleitpaste gefüllt oder wie bei Opto-IC's nach dem Kapseln mit einer glasklaren Masse ausgegossen werden.

Besonders vorteilhaft ist, daß die als Formteile vorgesehenen Halbschalen in einem weiten Bereich unterschiedlicher Anschlußzahl und Geometrie des Systemträgers immer gleich sein können, das heißt, daß Standardformteile zu verwenden sind.

Das Verfahren nach der Erfindung läßt sich relativ einfach automatisieren.

Außerdem besteht auch die Möglichkeit, die beiden Kunststoffhälften mit einem Kleber mit dem Systemträger und untereinander zu verbinden.

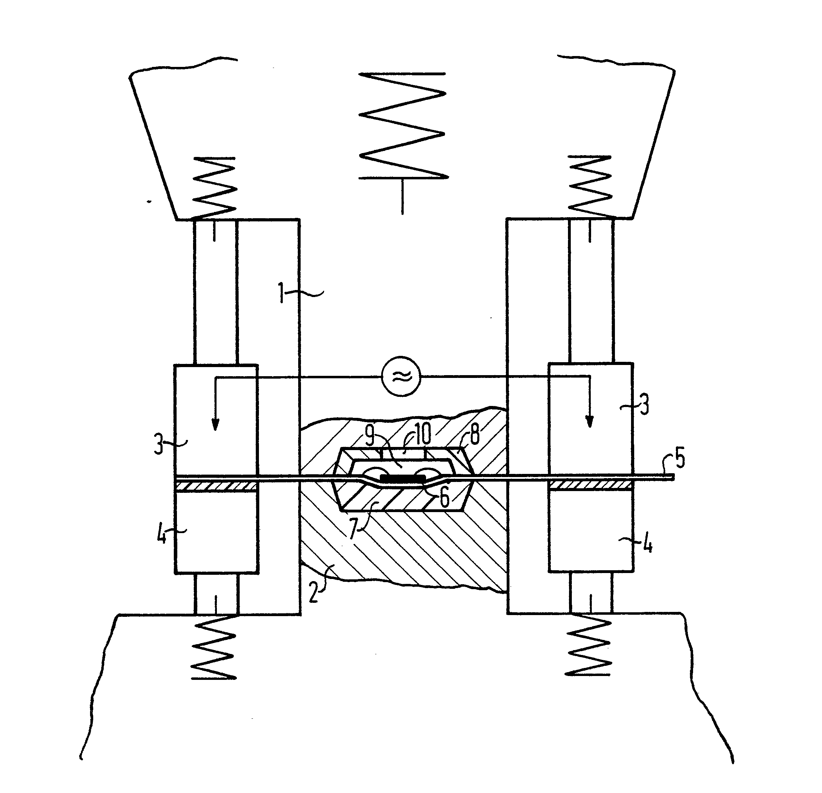

Die Erfindung wird anhand der Figur erläutert.

Zur Realisierung der Fügetechnik ist bei dem Ausführungsbeispiel eine Preßvorrichtung bestehend aus einem Stempel 1 und einem Tisch 2 vorgesehen. Ein Elektrodenpaar 3 dient der Wärmeerzeugung, z. B. über einen Stromimpuls. Auf einer Gegenlage 4 ist ein Ganzmetall-Systemträger 5 angeordnet. Ein IC-System 6 ist mit dem Systemträger kontaktiert. Der Systemträger liegt auf einer als Gehäuseboden dienenden Kunststoffhalbschale 7. Eine zweite Kunststoffhalbschale 8 dient als Gehäusedeckel. Der Innenraum zwischen den Halbschalen kann mit Höhlungen versehen und mit Wärmeleitpaste 9 ausgefüllt sein. Für Opto-IC's ist in dem Gehäusedeckel 8 ein Durchbruch 10 vorgesehen, so daß anstelle der Wärmeleitpaste eine Füllung mit optisch angepaßten Harzen erfolgen kann.

Nach dem Ausführungsbeispiel wird in der kleinen Preßvorrichtung nun die Kunststoffhalbschale 8 mit dem Durchbruch 10 in den Stempelkopf eingelegt und gehalten, während die andere Kunststoffhalbschale 7 zum Oberteil justiert auf dem Stempeltisch 2 aufliegt. Anschließend wird der Metallzwischenträger 5 mit der integrierten Schaltung zwischen die Stempel positionsgerecht eingelegt. Die Preßvorrichtung schließt sich und die Kunststoffhalbschalen 7, 8 liegen mit vorgegebenem Druck auf dem Systemträger 5. Dieser erhält einen definierten Wärmeimpuls, wodurch der sich damit in Kontakt befindliche Kunststoff anschmilzt und unter Zusammendrücken auf Anschlag den Ganzmetall-Systemträger umschließt. So werden die beiden als Halbschalen ausgebildeten Kunststoffformteile miteinander zu einem Gehäuse verschweißt.

Nachdem die Preßvorrichtung ihre gehäusedimensionierende Endlage erreicht hat, kühlt das Gehäuse ab. Die Preßvorrichtung öffnet und ist für den nächsten Preßtakt bereit.

Im folgenden kann bei Opto-Systemen die Fensteröffnung mit einer entsprechenden Harzfüllung versehen und einem Aushärteprozeß unterzogen werden. Anschließend folgt das Herausstanzen der fertigen, mit einem Kunststoffgehäuse geschützten Halbleiterschaltung aus dem Systemträger-

streifen und das Abbiegen der Kontaktstifte.

4 Patentansprüche
1 Figur

0009135

- 1 -    VPA 78 P 7 1 2 7

<u>Patentansprüche.</u>

1. Verfahren zur Herstellung einer Kunststoffkapselung für Halbleiterbauelemente auf einem metallischen Systemträger, d a d u r c h  g e k e n n z e i c h n e t , daß vorgefertigte Kunststoffhalbschalen (7, 8) über und unter dem Systemträger (5) mit dem Chip (6) definiert positioniert, der Systemträger kurzzeitig erwärmt und während dessen beide Halbschalen (7, 8) zusammengedrückt werden.

2. Kunststoffkapselung nach Anspruch 1, d a d u r c h  g e k e n n z e i c h n e t , daß die Halbschalen (7, 8) Höhlungen oder Durchbrüche (10) aufweisen.

3. Kunststoffkapselung nach Anspruch 1 und 2, d a - d u r c h  g e k e n n z e i c h n e t , daß die Halbschalen (7, 8) vor dem Kapseln mit einer Wärmeleitpaste gefüllt sind.

4. Kunststoffkapselung nach Anspruch 1 bis 3, d a - d u r c h  g e k e n n z e i c h n e t , daß die Halbschalen (7, 8) nach dem Kapseln mit einer Harzfüllung versehen werden.

# EUROPÄISCHER RECHERCHENBERICHT

| | EINSCHLÄGIGE DOKUMENTE | | KLASSIFIKATION DER ANMELDUNG (Int.Cl.3) |
|---|---|---|---|
| Kategorie | Kennzeichnung des Dokuments mit Angabe, soweit erforderlich, der maßgeblichen Teile | betrifft Anspruch | |
| X | DE - A1 - 2 607 083 (SEL) <br> * Ansprüche 1 bis 3, 11; Seite 11, Zeilen 7 bis 9, Zeilen 13 bis 19; Seite 12, Zeilen 17 bis 21; Seite 15, Zeilen 1 bis 10, Zeilen 16 bis 27; Fig. 3 * | 1,2,4 | H 01 L 21/96 <br> H 01 L 23/04 |
| A | DD - A - 66 901 (S. KREHER) <br> * Spalte 3, Zeile 16 bis Spalte 4, Zeile 8 * | 1 | **RECHERCHIERTE SACHGEBIETE (Int. Cl.3)** |
| A | US - A - 3 938 177 (AMP) <br> * Anspruch 13; Fig. 2, 4, 6 * | 1 | H 01 L 21/96 <br> H 01 L 23/00 |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 03-12-1979 | ROTHER |

EPA form 1503.1 06.78